# EUROPEAN PATENT SPECIFICATION

(11) **EP 3 591 905 B1**
(45) Date of publication and mention of the grant of the patent: **29.07.2020**
(21) Application number: 19162354.5
(22) Date of filing: 12.03.2019
(51) Int. Cl.: H04L 12/40, H02J 4/00

(54) **COMMUNICATION UNIT AND SAFETY SYSTEM**
KOMMUNIKATIONSEINHEIT UND SICHERHEITSSYSTEM
UNITÉ DE COMMUNICATION ET SYSTÈME DE SÉCURITÉ

(30) Priority: 04.07.2018 JP 2018127654
(43) Date of publication of application: 08.01.2020
(73) Proprietor: OMRON Corporation, Shiokoji-dori, Shimogyo-ku Kyoto-shi Kyoto 600-8530 (JP)
(72) Inventor: YAMAJI, Takamasa, KYOTO, 600-8530 (JP); HASHIMOTO, Minoru, KYOTO, 600-8530 (JP); HASEGAWA, Atsushi, KYOTO, 600-8530 (JP)
(74) Representative: 2K Patentanwälte Blasberg Kewitz & Reichel

(56) References cited:
- EP-A1- 2 720 414
- WO-A1-2017/149301
- DE-A1-102005 043 451
- US-A1- 2017 220 514

## Description

### BACKGROUND

### Technical Field

The present invention relates to a communication unit and a safety system.

### Description of Related Art

Safety systems to which a plurality of safety input devices (for example, a safety sensor, an emergency stop switch, and the like) are connected through a common bus line and which enable data communication or transmission of information between the safety input devices through the bus line have been proposed. For example, a safety system disclosed in Patent Document 1 is configured such that communication units serving as hubs to which safety input devices are connected through cables are connected to each other in series (cascade connection) through a common bus line.

### Patent Documents

[Patent Document 1] European Patent Application, Publication No. 2720414 (2016-09-13).

Other relevant prior art is given by patent publications WO 2017/149301 A1 (2017-09-08), DE 10 2005 043451 (2006-04-06) and US 2017/220514 A1 (2017-08-03).

### SUMMARY

However, in the related art described above, there are the following problems when actually installing and constructing a safety system.

That is, in a case where the safety system disclosed in Patent Document 1 is constructed, the common bus line connecting the communication units to each other is constructed, and thus a dedicated connection cable is required. For this reason, there is a problem that initial cost increases due to purchase of the dedicated connection cable, and an increase in man-hours such as for connection between the communication units through the connection cable.

The invention provides a communication unit and a safety system in which increase in initial cost when constructing the safety system is able to be minimized.

According to an embodiment, there is provided a communication unit including a unit main body, a connection portion which is provided in the unit main body and connected to a safety input device through a cable, a first input and output portion which is provided at a first end on a connection portion side in the unit main body, and a second input and output portion which is provided at a second end on a side opposite to the first end in the unit main body, in which the first and second input and output portions are configured to be directly connected to each other when a plurality of the unit main bodies are connected to each other in series, and a notched portion forming a disposition space for a terminal on the connection portion side of at least the cable is provided at the second end of the unit main body.

According to the above-described configuration, the first and second input and output portions are configured to be directly connected to each other when a plurality of the unit main bodies are connected to each other in series, and thus a dedicated connection cable is not required to connect the communication units to each other. In addition, since a notched portion forming a disposition space for a terminal on the connection portion side of at least the cable is provided at the second end of the unit main body, the terminal on the connection portion side of the cable does not interfere with another adjacent unit main body when connecting the communication units to each other in series. For this reason, according to the above-described configuration, a terminal on the connection portion side of the cable does not protrude from the unit main body, and thus it is possible to prevent breakage of the communication unit due to contact with a user.

Therefore, according to the above-described configuration, it is possible to minimize increase in initial cost when constructing a safety system.

Further, in the communication unit according to the embodiment, it is preferable that the safety input device is disposed to be shifted from the serial direction of the unit main bodies, the cable is disposed to be bent on the connection portion side, and the notched portion has a surface forming an installation space for a bent portion of the cable.

According to the above-described configuration, the bent portion of the cable connected to the unit main body does not interfere with another adjacent unit main body when connecting the communication units to each other in series.

Further, in the communication unit according to the embodiment, it is preferable that the terminal on at least the connection portion side in the cable has a linear shape extending in a connection direction of the unit main bodies.

According to the above-described configuration, it is possible to reliably prevent the terminal on the connection portion side of the cable from protruding from the unit main body.

According to another embodiment, there is also provided a safety system including a plurality of the communication units according to any one of claims 1 to 3, which are connected to each other in series, the safety input device which is connected to each of the communication units, and an input unit which relays transmission of information, which is input from the communication unit, to a controller, in which the communication units are directly connected to each other.

According to the above-described configuration, it is possible to realize a safety system in which an increase in initial cost when constructing the safety system is able to be minimized.

According to an aspect of the invention, it is possible to minimize the increase in initial cost when constructing the safety system.

### BRIEF DESCRIPTION OF THE DRAWINGS

FIG. 1 is a side view showing a configuration of a safety system according to an embodiment of the invention.
FIG. 2 is a perspective view showing a configuration of the safety system according to the embodiment of the invention.
FIG. 3 is a functional block diagram showing a schematic configuration of the safety system according to the embodiment of the invention.
FIGS. 4A and 4B are side views showing a modification example of a notched portion of a unit main body in a communication unit according to the embodiment of the invention.
FIG. 5 is a side view showing a configuration of a mounting hole of the unit main body in the communication unit according to the embodiment of the invention.

### DESCRIPTION OF THE EMBODIMENTS

### §1 Application Example

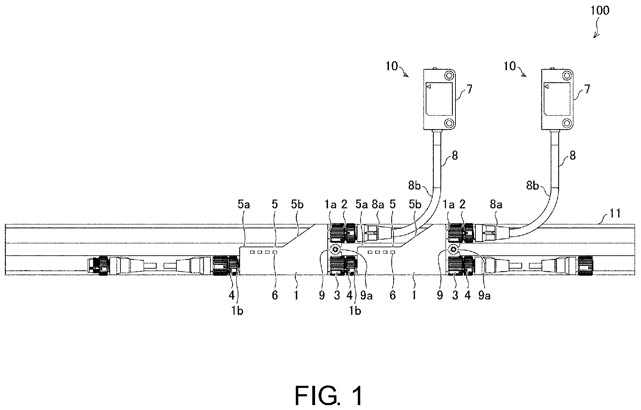

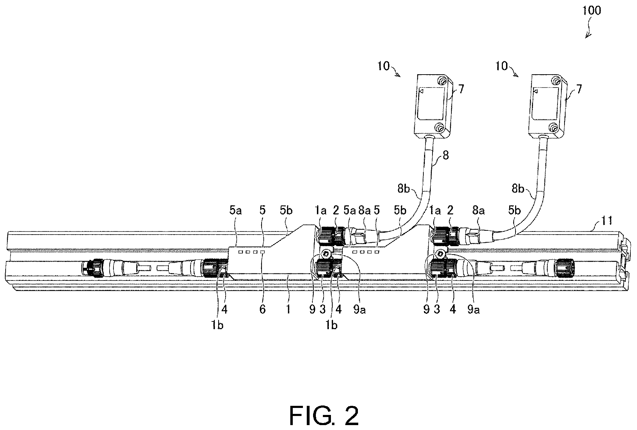

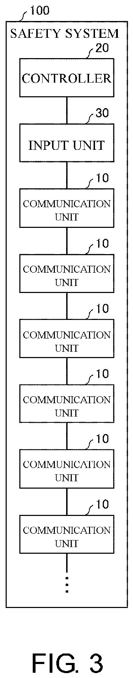

Hereinafter, an embodiment of the invention will be described in detail. FIG. 1 is a side view showing a configuration of a safety system 100 according to the present embodiment. FIG. 2 is a perspective view showing a configuration of the safety system 100 shown in FIG. 1. FIG. 3 is a functional block diagram showing a schematic configuration of the safety system 100 according to the present embodiment.

First, as shown in FIG. 3, the safety system 100 includes a plurality of communication units 10 connected to each other in series, a controller 20, and an input unit 30. The plurality of communication units 10 connected to each other in series are connected to the controller 20 through the input unit 30.

Firstly, the controller 20 acquires information from the plurality of communication units 10 through the input unit 30 as input data. Secondly, the controller 20 executes arithmetic processing using the acquired input data in accordance with a preinstalled user program. The controller 20 executes the arithmetic processing to determine control contents with respect to the plurality of communication units 10.

The input unit 30 is a relay device for performing transmission and reception of data between the communication units 10 and the controller 20. The input unit 30 is a device communication management unit for the controller 20 to capture information relating to the state of the communication unit 10 which is an input source, and the like (input information and additional information). One or more communication units 10 are connected to the input unit 30 through a device communication cable. The input unit 30 includes a device communication port to which the device communication cable for communicating with one or more communication units 10 connected to each other in series is connected.

In the safety system 100, the controller 20 receives information and the like (input information) detected by the communication unit 10 through the input unit 30. It is noted that a human machine interface (HMI) may be connected to the controller 20 through, for example, a universal serial bus (USB) cable. The HMI is a means for exchanging information between a human and a machine, and specifically, is a means for causing a human to operate a machine (gives an instruction to a machine) or causing a machine to inform a human of the present state and result. Regarding the HMI, the means by which a human gives instructions to a machine includes, for example, a switch, a button, a handle, a dial, a pedal, a remote control, a microphone, a keyboard, a mouse, and the like. In addition, the means by which a machine informs a human of information regarding the present state, result, and the like includes, for example, a liquid crystal screen, a meter, a lamp, a speaker, and the like.

As shown in FIGS. 1 and 2, the safety system 100 according to the present embodiment is configured such that the plurality of communication units 10 are connected to each other in series. The communication unit 10 includes a unit main body 1. In the safety system 100, a plurality of the unit main bodies 1 are connected to each other in series, and a safety input device 7 is connected to each of the unit main bodies 1 through a cable 8.

The unit main body 1 includes a cable connection portion 2 (connection portion) connected to the cable 8, an input and output portion 3 (first input and output portion), an input and output portion 4 (second input and output portion), a notched portion 5, a status display unit 6, and a mounting hole 9.

The input and output portion 3 is provided at an end 1a (first end) on the cable connection portion 2 side in the unit main body 1. In addition, the input and output portion 4 is provided at an end 1b (second end) on a side opposite to the end 1a in the unit main body 1. The input and output portions 3 and 4 are configured to be directly connected to each other when the plurality of unit main bodies 1 are connected to each other in series. The input and output portions 3 and 4 are not connected through a cable.

The status display unit 6 displays communication conditions between the communication units 10 within the safety system 100. In a case where an abnormality occurs in the communication conditions between the communication units 10 within the safety system 100, the status display unit 6 of the communication unit 10 having an abnormality is configured to display a communication abnormality. It is noted that the number of status display units 6 is not limited to that in the configurations shown in FIGS. 1 and 2 and may be any number.

The mounting hole 9 is a portion for mounting the unit main body 1 on an aluminum frame 11. The unit main body 1 is fixed to the aluminum frame 11 by a fastening member 9a through the mounting hole 9.

As shown in FIGS. 1 and 2, the safety system 100 is configured by mounting the communication units 10 on the aluminum frame 11 used, for example, for a casing frame of a production facility.

When such a safety system in which the communication units are connected to each other in series is constructed, a dedicated connection cable is required in the related art to connect the plurality of communication units 10 to each other in series. However, in the safety system 100 according to the present embodiment, the plurality of communication units 10 are directly connected to each other through the input and output portions 3 and 4. Therefore, a dedicated connection cable is not required to connect the communication units 10 to each other.

Further, in a case where the communication units 10 are connected to each other in series, a connection portion-side terminal 8a of the cable 8 interferes in the unit main body 1 of another adjacent communication unit 10, and it is difficult to mount the cable 8 on the cable connection portion 2. In order to prevent interference of the cable 8 with the unit main body 1, it is conceivable that the connection portion-side terminal 8a of the cable 8 is formed to have an L-shape. However, in this case, there is a concern that the connection portion-side terminal 8a may protrude from the aluminum frame 11. In addition, when a user comes into contact with the protruding connection portion-side terminal 8a, there is a concern that a production line may stop due to breakage of the communication unit 10.

Consequently, in the communication unit 10 according to the present embodiment, the notched portion 5 is provided at the end 1b in the unit main body 1. The notched portion 5 has a plane 5a. The plane 5a forms an installation space of at least the connection portion-side terminal 8a in the cable connection portion 2 of the adjacent communication unit 10. Therefore, the dimensions of the plane 5a in the notched portion 5 are larger than the dimensions of the connection portion-side terminal 8a. According to the communication unit 10 of the present embodiment, the notched portion 5 constituting the installation space of at least the connection portion-side terminal 8a is provided at the end 1b in the unit main body 1. Accordingly, when the unit main bodies 1 are directly connected to each other, the connection portion-side terminal 8a connected to the unit main body 1 is accommodated in the notched portion 5 formed in another adjacent unit main body 1. For this reason, the connection portion-side terminal 8a connected to the unit main body 1 does not interfere with another adjacent unit main body 1 when connecting the communication units 10 to each other in series. For this reason, the connection portion-side terminal 8a does not protrude from the aluminum frame 11, and thus it is possible to prevent breakage of the communication unit 10 due to a contact with a user.

Therefore, according to the communication unit 10 of the present embodiment, it is possible to minimize an increase in initial cost in constructing the safety system 100.

In addition, as shown in FIGS. 1 and 2, the safety input device 7 is disposed to be shifted from a serial direction of the unit main bodies 1. In addition, thereby, the cable 8 connected to the safety input device 7 is disposed to be bent on the cable connection portion 2 side. More specifically, the cable 8 has a bent portion 8b which is bent in a direction perpendicular to the serial direction of the unit main bodies 1.

The notched portion 5 has an inclined surface 5b forming the installation space of the bent portion 8b of the cable 8. Thereby, the bent portion 8b of the cable 8 connected to the unit main body 1 does not interfere with another adjacent unit main body 1 when connecting the communication units 10 to each other in series.

It is noted that the notched portion 5 may be configured to form the installation space of at least the connection portion-side terminal 8a. For example, in a case where the cable 8 has an extremely high flexibility, it is conceivable that the bent portion 8b of the cable 8 be formed to be not too large. Therefore, it is conceivable that the degree of interference of the bent portion 8b with respect to the unit main body 1 is low. In such a case, in the notched portion 5, the inclined surface 5b along the bent portion 8b of the cable 8 may not be formed.

### §2 Configuration Example

### <Safety System 100>

The safety system 100 according to the present embodiment is configured to include a power supply unit that supplies a voltage for the supply of a current to at least one communication unit 10. The power supply unit may be connected to the cable connection portion 2 in the communication unit 10 and the input and output portions 3 and 4 through a cable. Therefore, the input and output portions 3 and 4 are used not only for direct connection between the unit main bodies 1 but also for connection to the power supply unit.

In addition, the controller 20 connected to the plurality of communication units 10 connected to each other in series may be an industrial control device such as a programmable logic controller (PLC).

In addition, examples of the safety input device 7 include a "detector" such as a temperature sensor or an optical sensor, a "switch (a push button switch, a limit switch, a pressure switch, a non-contact switch, or the like)", "safety equipment (a safety controller or the like)", and the like.

### <Unit Main Body 1 and Cable 8>

Dimensions of the unit main body 1 can be appropriately set in accordance with a location where the unit main body 1 is installed. In addition, a known cable of the related art used for a communication system can be adopted as the cable 8. The cable 8 is, for example, a cable having a diameter of Φ5 mm to 6 mm and having a connector portion of the M8 or M12 standard. In addition, the length of the cable 8 can be appropriately set in accordance with a facility configuration of the safety system 100, or the like. For example, in a case where a non-contact switch is used as the safety input device 7, the length of the cable 8 is 2 m to 5 m.

The input and output portions 3 and 4 in the unit main body 1 are not particularly limited as long as the input and output portions are configured to be able to be directly connected to each other. For example, in a case where the input and output portion 3 is constituted by a male terminal, the input and output portion 4 is constituted by a female terminal capable of being connected to the male terminal.

In addition, the cable connection portion 2 and the connection portion-side terminal 8a of the cable 8 are not particularly limited as long as the cable connection portion and the connection portion-side terminal are configured to be able to be connected to each other. The connection portion-side terminal 8a may be a male terminal or a female terminal. In addition, it is preferable that the shape of the connection portion-side terminal 8a of the cable 8 is a linear shape extending in the connection direction of the unit main bodies 1 instead of being an L-shape in order not to protrude from the aluminum frame 11. In addition, it is preferable that the connection portion-side terminal 8a is a terminal formed by overmolding.

For example, in a case where the unit main body 1 has such dimensions as to be installed in the aluminum frame 11 of which the cross-sectional shape is a square shape of 40 mm×40 mm, it is preferable that the connection portion-side terminal 8a has the following dimensions. In a case where the connection portion-side terminal 8a is a male terminal, a maximum of the diameter thereof is 16 mm, and the length thereof is 55 mm. Further, in a case where the connection portion-side terminal 8a is a female terminal, a maximum of the diameter thereof is 16 mm, and the length thereof is 48 mm. The connection portion-side terminal 8a has dimensions based on the IEC standard 61076-2. With such dimensions, the connection portion-side terminal 8a does not protrude from the aluminum frame 11.

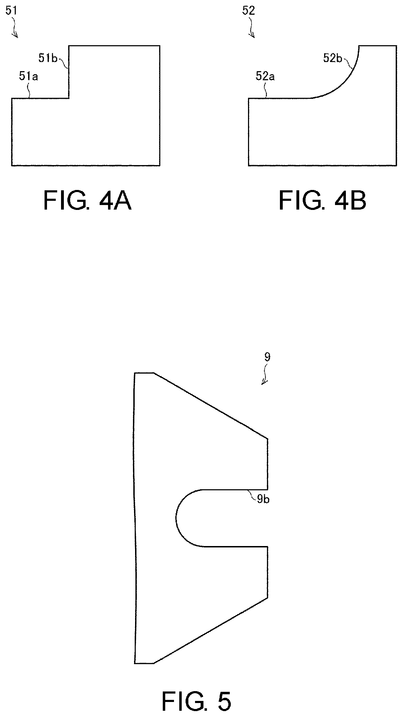

In the configurations shown in FIGS. 1 and 2, the notched portion 5 has the inclined surface 5b forming the installation space of the bent portion 8b of the cable 8. However, the notched portion 5 is not limited to the inclined surface 5b as long as the notched portion forms the installation space of the bent portion 8b of the cable 8, and may have any surface. FIG. 4A and FIG. 4B are side views showing a modification example of a notched portion of the unit main body 1 in the communication unit 10 according to the present embodiment.

As shown in FIG. 4A, a notched portion 51 may have a plane 51a and a perpendicular plane 51b. The perpendicular plane 51b is formed to be perpendicular to the plane 51a. In the notched portion 51, the plane 51a is a surface forming the installation space of the connection portion-side terminal 8a, and the perpendicular plane 51b is a surface forming the installation space of the bent portion 8b of the cable 8.

In addition, as shown in FIG. 4B, the notched portion 52 may have a plane 52a and a curved surface 52b. In the notched portion 52, the plane 52a is a surface forming the installation space of the connection portion-side terminal 8a, and the curved surface 52b is a surface forming the installation space of the bent portion 8b of the cable 8.

FIG. 5 is a side view showing a configuration of the mounting hole 9 of the unit main body 1. As shown in FIG. 5, the mounting hole 9 has an elongated hole 9b. The unit main body 1 is fixed to the aluminum frame 11 by inserting the fastening member 9a into the elongated hole 9b and fastening the fastening member 9a and the aluminum frame 11 to each other. The fastening member 9a may be a member capable of being fastened to the aluminum frame 11 and the like and is, for example, a cross slot screw, a hexagon head bolt, or the like. In addition, the mounting hole 9 may be configured such that the fastening member 9a is inserted thereinto, and may have a circular hole instead of the elongated hole 9b shown in FIG. 5.

In addition, the mounting hole 9 may include an auxiliary member that assists fastening, in addition to the fastening member 9a. Examples of such an auxiliary member include a washer, a washer ring, and the like.

The invention is not limited to the above-described embodiment and can be modified in the scope recited in the claims.

### [Reference Signs List]

1 Unit main body
1a End (first end)
1b End (second end)
2 Cable connection portion (connection portion)
3 Input and output portion (first input and output portion)
4 Input and output portion (second input and output portion)
5, 51, 52 Notched portion
5b Inclined surface (surface forming installation space of bent portion of cable)
7 Safety input device
8 Cable
8a Connection portion-side terminal
8b Bent portion
10 Communication unit
51b Perpendicular plane (surface forming installation space of bent portion of cable)
52b Curved surface (surface forming installation space of bent portion of cable)
100 Safety system

## Claims

1. A communication unit (10) comprising:
a unit main body (1);
a connection portion (2) which is provided in the unit main body (1) and connectable to a safety input device (7) through a cable (8);
a first input and output portion (3) which is provided at a first end (1a) on a connection portion side in the unit main body (1); and **characterized by**
a second input and output portion (4) which is provided at a second end (1b) on a side opposite to the first end (1a) in the unit main body (1),
wherein the first input and output portion (3) and the second input and output portion (4) are configured to be directly connected to each other when a plurality of the unit main bodies are connected to each other in series, and
a notched portion (5, 51, 52) forming a disposition space for a terminal (8a) on the connection portion side of the cable, provided at the second end (1b) of the unit main body (1).

2. The communication unit (10) according to claim 1,
wherein the safety input device (7) is disposed to be shifted from a serial direction of the unit main bodies, and the cable is disposed to be bent on the connection portion side, and
the notched portion (5, 51, 52) has a surface (5b) forming an installation space of a bent portion (8b) of the cable.

3. The communication unit according to claim 1 or 2,
wherein the terminal (8a) on at least the connection portion side in the cable has a linear shape extending in a connection direction of the unit main bodies.

4. A safety system (100), **characterized in that**, the safety system (100) comprises:
a plurality of the communication units (10) according to any one of claims 1 to 3, which are connected to each other in series;
the safety input device (7) which is connected to each of the communication units (10); and
an input unit (30) which is arranged to relay transmission of information, which is input from the communication unit (10), to a controller,
wherein the communication units (10) are directly connected to each other.

## Patentansprüche

1. Kommunikationseinheit (10), umfassend:
eine Hauptkörpereinheit (1);
einen Verbindungsabschnitt (2), der in der Hauptkörpereinheit (1) vorgesehen ist und über ein Kabel (8) mit einer Sicherheitseingabevorrichtung (7) verbunden werden kann;
einen ersten Eingabe- und Ausgabeabschnitt (3), der an einem ersten Ende (1a) auf einer Verbindungsabschnittsseite in der Hauptkörpereinheit (1) vorgesehen ist; und **gekennzeichnet durch**
einen zweiten Eingabe- und Ausgabeabschnitt (4), der an einem zweiten Ende (1b) auf einer dem ersten Ende (1a) gegenüberliegenden Seite in der Hauptkörpereinheit (1) vorgesehen ist,
wobei der erste Eingabe- und Ausgabeabschnitt (3) und der zweite Eingabe- und Ausgabeabschnitt (4) so konfiguriert sind, dass diese direkt miteinander verbunden sind, wenn eine Mehrzahl von Hauptkörpereinheiten in Reihe miteinander verbunden sind, und
einen eingekerbten Abschnitt (5, 51, 52), der einen Anordnungsraum für einen Anschluss (8a) auf der Seite des Verbindungsabschnitts des Kabels bildet und am zweiten Ende (1b) der Hauptkörpereinheit (1) vorgesehen ist.

2. Kommunikationseinheit (10) nach Anspruch 1,
wobei die Sicherheitseingabevorrichtung (7) so angeordnet ist, dass diese aus einer seriellen Richtung der Hauptkörpereinheiten verschoben werden kann, und das Kabel so angeordnet ist, dass es auf der Seite des Verbindungsabschnitts gebogen werden kann, und
der eingekerbte Abschnitt (5, 51, 52) eine Oberfläche (5b) aufweist, die einen Installationsraum eines gebogenen Abschnitts (8b) des Kabels bildet.

3. Kommunikationseinheit nach Anspruch 1 oder 2,
wobei der Anschluss (8a) mindestens auf der Seite des Verbindungsabschnitts in dem Kabel eine lineare Form aufweist, die sich in einer Verbindungsrichtung der Hauptkörpereinheit erstreckt.

4. Sicherheitssystem (100), **dadurch gekennzeichnet, dass** das Sicherheitssystem (100) umfasst:
eine Mehrzahl von Kommunikationseinheiten (10) nach einem der Ansprüche 1 bis 3, die in Reihe miteinander verbunden sind;
die Sicherheitseingabevorrichtung (7), die mit jeder der Kommunikationseinheiten (10) verbunden ist; und
eine Eingabeeinheit (30), die so angeordnet ist, dass diese die Übertragung von Informationen, die von der Kommunikationseinheit (10) eingegeben werden, an eine Steuerung weiterleitet,
wobei die Kommunikationseinheiten (10) direkt miteinander verbunden sind.

## Revendications

1. Une unité de communication (10) comprenant :
un corps principal d'unité (1) ;
une partie de connexion (2) qui est prévue dans le corps principal de l'unité (1) et qui peut être connectée à un dispositif d'entrée de sécurité (7) par un câble (8) ;
une première partie d'entrée et de sortie (3) qui est prévue à une première extrémité (1a) du côté de la partie de connexion dans le corps principal de l'unité (1); et **caractérisée par**
une deuxième partie d'entrée et de sortie (4) qui est prévue à une deuxième extrémité (1b) sur un côté opposé à la première extrémité (1a) dans le corps principal de l'unité (1),
dans lequel la première partie d'entrée et de sortie (3) et la deuxième partie d'entrée et de sortie (4) sont configurées pour être directement connectées l'une à l'autre lorsqu'une pluralité de corps principaux d'unité sont connectés les uns aux autres en série, et
une partie entaillée (5, 51, 52) formant un espace de disposition pour un port (8a) du côté de la partie de connexion du câble, prévue à la deuxième extrémité (1b) du corps principal de l'unité (1).

2. L'unité de communication (10) selon la revendication 1,
dans lequel le dispositif d'entrée de sécurité (7) est disposé de manière à être décalé d'une direction série des corps principaux de l'unité, et le câble est disposé de manière à être plié du côté de la partie de connexion, et
la partie entaillée (5, 51, 52) présente une surface (5b) formant un espace d'installation d'une partie coudée (8b) du câble.

3. L'unité de communication selon la revendication 1 ou 2,
dans laquelle le port (8a), au moins du côté de la partie de connexion dans le câble, a une forme linéaire s'étendant dans une direction de connexion des corps principaux de l'unité.

4. Un système de sécurité (100), **caractérisé en ce que**, le système de sécurité (100) comprend :
une pluralité d'unités de communication (10) selon quelconque des revendications 1 à 3, qui sont connectées les unes aux autres en série;
le dispositif d'entrée de sécurité (7) qui est connecté à chacune des unités de communication (10); et
une unité d'entrée (30) qui est agencée pour relayer la transmission des informations, qui sont entrées par l'unité de communication (10), à un contrôleur,
où les unités de communication (10) sont directement connectées entre elles.
